(19) Europäisches Patentamt
European Patent Office
Office européen des brevets

(11) **EP 3 454 010 B1**

(12) **FASCICULE DE BREVET EUROPEEN**

(45) Date de publication et mention de la délivrance du brevet:
**18.11.2020   Bulletin 2020/47**

(51) Int Cl.:
***G01C 17/38*** *(2006.01)*

(21) Numéro de dépôt: **18191497.9**

(22) Date de dépôt: **29.08.2018**

(54) **PROCÉDÉ DE COMPENSATION D'UN CHAMP MAGNÉTIQUE, DISPOSITIF ET PROGRAMME D'ORDINATEUR ASSOCIÉS**

KOMPENSATIONSVERFAHREN EINES MAGNETFELDS, ENTSPRECHENDE VORRICHTUNG UND ENTSPRECHENDES COMPUTERPROGRAMM

METHOD FOR COMPENSATING A MAGNETIC FIELD, ASSOCIATED DEVICE AND COMPUTER PROGRAM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.09.2017   FR 1700903**

(43) Date de publication de la demande:
**13.03.2019   Bulletin 2019/11**

(73) Titulaire: **Thales**
**92400 Courbevoie (FR)**

(72) Inventeur: **VERCIER, Nicolas Jean-Marc Frédéric**
**26000 Valence (FR)**

(74) Mandataire: **Lavoix**
**2, place d'Estienne d'Orves**
**75441 Paris Cedex 09 (FR)**

(56) Documents cités:
**EP-A1- 0 718 598     US-A1- 2004 236 510**

**Description**

La présente invention concerne le domaine de la compensation d'un champ magnétique dans la détermination du cap magnétique d'un engin, sur la base des mesures d'un capteur de champ magnétique embarqué à bord de l'engin.

Un tel engin est par exemple un aéronef.

Les mesures d'un capteur de champ magnétique embarqué sont généralement entachées d'erreurs, dues à des perturbations magnétiques (perturbations dites de fer doux et perturbations dites de fer dur) et/ou à un problème d'alignement entre le trièdre référentiel de l'engin et le trièdre référentiel du capteur de champ magnétique. C'est pourquoi il s'avère nécessaire, pour obtenir des valeurs de cap de bonne qualité, de procéder, à partir des valeurs mesurées de champ magnétique, à une opération de compensation de ces erreurs, pour déterminer des valeurs compensées de champ magnétique, ainsi affranchies, au moins partiellement, de ces erreurs.

L'opération de compensation comprend généralement une phase de calibration de compensation définissant une matrice A correspondant aux perturbations dites de fer doux et au problème d'alignement, et un vecteur B correspondant aux perturbations dites de fer dur.

On connaît par exemple le document EP 0 718 598 B1 proposant une solution de compensation d'un magnétomètre.

- Plus précisément, la présente invention concerne un procédé de compensation d'un champ magnétique déterminé à l'aide d'un capteur de champ magnétique embarqué à bord d'un engin en vue de calculer le cap magnétique dudit engin, ledit procédé comprenant les étapes mises en œuvre par ordinateur et consistant à : pour chaque temps de mesure $T_i$, i= 1 à N avec N>1, on collecte les valeurs du champ magnétique 3D $Hm_i$ en provenance du capteur de champ magnétique et celles des angles $\theta_i$ etet $\varphi_i$, où $\theta_i$ est le tangage de l'engin et $\varphi_i$ est le roulis de l'engin ;
- on détermine une matrice A et un vecteur B en fonction au moins desdites valeurs collectées de champ magnétique $Hm_i$ et des angles $\theta_i$ et $\varphi_i$, i= 1 à N, la matrice A représentant les perturbations de fer doux et de non-alignement entre l'engin et le capteur de champ magnétique et le vecteur B représentant les perturbations de fer dur.

La calibration de compensation est toutefois difficile à réaliser à haute latitude (par exemple, les latitudes supérieures à 60° ou à 70°), du fait d'un rapport signal à bruit alors réduit (en effet, à haute latitude, les valeurs des deux composantes horizontales du champ magnétique deviennent très inférieures à la valeur de la composante verticale du champ magnétique). Le problème est généralement contourné en calibrant la compensation à latitude faible, mais cela n'est pas toujours possible, notamment lorsque le capteur de champ magnétique doit être remplacé dans un aéroport à haute latitude.

A cet effet, suivant un premier aspect, l'invention propose un procédé de compensation d'un champ magnétique du type précité caractérisé en ce que la détermination de la matrice A et du vecteur B comprend une étape d'estimation du couple (A,B) minimisant l'expression

$$\sum_{i=1 \text{ à } N}\left(\|A(Hm_i-B)\| - \frac{1}{N}\sum_{i=1 \text{ à } N}\big(\|A(Hm_i-B)\|\big)\right)^2 + \sum_{i=1 \text{ à } N}\left(V_iA(Hm_i-B) - \frac{1}{N}\sum_{i=1 \text{ à } N}(V_iA(Hm_i-B))\right)^2$$

où $V_i$ = [-sin($\theta_i$) ; sin($\varphi_i$).cos($\theta_i$) ; cos($\varphi_i$).cos($\theta_i$)].

L'invention permet de fournir une solution de compensation de bonne qualité, même calibrée à haute latitude.

Dans des modes de réalisation, le procédé de compensation d'un champ magnétique suivant l'invention comporte en outre une ou plusieurs des caractéristiques suivantes :

- une opération de filtrage passe-bas, dont la fréquence de coupure est supérieure à la bande passante de la trajectoire de l'engin, est appliquée sur les valeurs des champs magnétiques $Hm_i$ et des angles $\theta_i$ et $\varphi_i$, ladite étape d'estimation du couple (A,B) étant réalisée en fonction desdites valeurs filtrées ;
- l'étape d'estimation du couple (A,B) minimisant ladite expression est réalisée par un algorithme itératif de descente de gradient de ladite expression ;
- on détermine un cap magnétique de l'engin en fonction d'un champ magnétique compensé, ledit champ magnétique compensé étant fonction d'au moins un champ magnétique déterminé à l'aide du capteur de champ magnétique, de ladite matrice A et dudit vecteur B précédemment déterminés.

Suivant un deuxième aspect, la présente invention propose un dispositif de compensation d'un champ magnétique déterminé à bord d'un engin, ledit dispositif étant adapté pour collecter pour chaque temps de mesure $T_i$, i= 1 à N avec N>1, des valeurs du champ magnétique 3D mesuré $Hm_i$ et celles des angles $\theta_i$ et $\varphi_i$, où $\theta_i$ est le tangage de l'engin

et $\varphi_i$ est le roulis de l'engin et pour déterminer une matrice A et un vecteur B en fonction au moins desdites valeurs collectées de champ magnétique $Hm_i$ et des angles $\theta_i$ et $\varphi_i$, i= 1 à N, la matrice A représentant les perturbations de fer doux et de non-alignement entre l'engin et le capteur de champ magnétique et le vecteur B représentant les perturbations de fer dur ; ledit dispositif étant caractérisé en ce que, lors de la détermination de la matrice A et du vecteur B, il est adapté pour estimer le couple (A,B) en minimisant l'expression

$$\sum_{i=1 \, à \, N}\left(\left\|A(Hm_i - B)\right\| - \frac{1}{N}\sum_{i=1 \, à \, N}\left(\left\|A(Hm_i - B)\right\|\right)\right)^2 + \sum_{i=1 \, à \, N}\left(V_i A(Hm_i - B) - \frac{1}{N}\sum_{i=1 \, à \, N}(V_i A(Hm_i - B))\right)^2$$

où $V_i = [-\sin(\theta_i) ; \sin(\varphi_i).\cos(\theta_i) ; \cos(\varphi_i).\cos(\theta_i)]$.

Suivant un troisième aspect, la présente invention propose un programme d'ordinateur comportant des instructions logicielles qui, lorsqu'elles sont exécutées par un ordinateur, mettent en œuvre un procédé suivant le premier aspect.

Ces caractéristiques et avantages de l'invention apparaîtront à la lecture de la description qui va suivre, donnée uniquement à titre d'exemple, et faite en référence aux dessins annexés, sur lesquels :

- la figure 1 représente une vue schématique d'un système de détermination de cap d'un avion dans un mode de réalisation de l'invention ;
- la figure 2 est un organigramme d'étapes mises en œuvre dans un mode de réalisation de l'invention ;
- les figures 3 et 4 illustrent le résultat de compensations différentes effectuées à partir des mêmes données initiales.

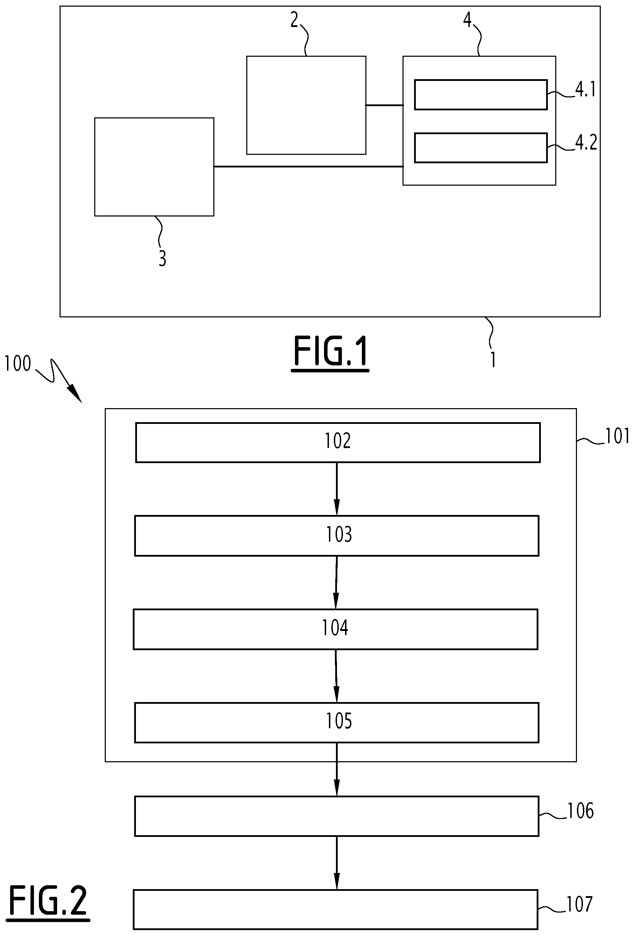

La figure 1 représente une vue schématique d'un système 1 de détermination de cap dans un mode de réalisation de l'invention, embarqué dans le cas considéré, à bord d'un avion (non représenté). Ce système 1 de détermination de cap est adapté pour déterminer le cap de l'avion. Il comprend un capteur de champ magnétique 2, une centrale à inertie 3 et un bloc de calcul de cap 4.

Le capteur de champ magnétique 2 est adapté pour, de façon connue, mesurer, dans un référentiel $R_a$ qui lui est associé et qui est théoriquement identique à celui associé à l'avion (c'est-à-dire avec un axe $X_a$ longitudinal passant par la tête et la queue de l'avion, un axe $Y_a$ perpendiculaire à X dirigé vers l'aile droite et un axe $Z_a$ perpendiculaire aux deux précédents axes pour former un trièdre direct, la valeur du vecteur H de champ magnétique présent localement et pour fournir, au bloc de calcul de cap 4, les valeurs du champ magnétique mesurées à des temps de mesure successifs. Dans le cas considéré, le capteur de champ magnétique 2 est un magnétomètre.

La centrale à inertie 3 comporte, de façon connue, 3 gyromètres et 3 accéléromètres et est adaptée pour intégrer les mouvements de l'avion (accélération et vitesse angulaire) et pour estimer, dans un référentiel de base R comportant un axe Z orienté vers le centre de la Terre donnant donc la verticale locale, un axe X dirigé vers le nord et un axe Y dirigé vers l'est, localement perpendiculaires entre eux et à l'axe Z, son orientation (angles de roulis, de tangage et de cap), sa vitesse linéaire et sa position. La centrale à inertie 3 est adaptée pour fournir, au bloc de calcul de cap 4, les valeurs des angles de roulis, de tangage et de cap estimées à l'issue des mesures à des temps de mesure successifs.

Le bloc de calcul de cap 4 est adapté pour effectuer la compensation, dans les champs magnétiques mesurés par le magnétomètre 2, des perturbations suivantes :

- perturbations de fer doux, correspondant à l'influence à proximité du magnétomètre 2, d'éléments ferromagnétiques non complètement magnétisés qui se magnétisent sous l'influence du champ externe ;
- perturbations dites de fer dur, dues à la présence de matériaux ferromagnétiques magnétisés de l'avion ; et
- problème d'alignement entre le référentiel de l'avion et celui du magnétomètre, du fait de défauts d'installation.

Le champ magnétique mesuré compensé Hc exprimé dans le référentiel $R_a$ se déduit du champ magnétique mesuré Hm à partir de la relation suivante :

$Hc = A(Hm - B)$, avec Hm = H + n, où H est le champ magnétique (non bruité) présent à l'endroit de mesure, ainsi

$$Hc = A\left(H + n - B\right),$$

où :

- A, matrice de taille 3*3, représente la matrice de fer doux, correspondant aux perturbations de fer doux et prenant aussi en compte les problèmes d'alignement ; B, vecteur de taille 3*1, représente le vecteur de fer dur correspondant aux perturbations de fer dur. Cette composante tourne avec le magnétomètre 2 et donc avec l'avion ;

- n représente le bruit et les autres perturbations locales non modélisées sur le champ magnétique mesuré.

Avant la description des étapes mises en œuvre dans le mode de réalisation décrit ici, quelques observations préliminaires et hypothèses considérées sont données ci-dessous.

L'opération de compensation du champ magnétique vise à annuler l'influence des problèmes d'alignement, fers doux et des fers durs et obtenir le champ compensé local (ou un champ proportionnel au champ local puisque seul le ratio entre les composantes du champ est utile pour calculer le cap) à partir du champ mesuré, et d'en déduire le cap de l'avion.

Les hypothèses retenues pour le calcul du champ magnétique compensé sont les suivantes :

Hyp1 : la norme du champ réel compensé est constante ;
Hyp2 : le champ vertical compensé est constant dans le référentiel de base R.

La matrice A et le vecteur B qui seront utilisés pour déterminer le champ compensé local, sont, selon l'invention et comme détaillé ci-après en référence à la figure 2 dans un mode particulier de mise en œuvre de l'invention, estimés comme minimisant l'expression suivante nommée C1, dont le premier groupe de termes traduit la première hypothèse, Hyp1, tandis que le second groupe de termes traduit la deuxième hypothèse, Hyp2 :

$$C1 = \sum_{i=1 \text{ à } N} \left( \left\| A(Hm_i - B) \right\| - \frac{1}{N} \sum_{i=1 \text{ à } N} \left( \left\| A(Hm_i - B) \right\| \right) \right)^2 + \sum_{i=1 \text{ à } N} \left( V_i A(Hm_i - B) - \frac{1}{N} \sum_{i=1 \text{ à } N} (V_i A(Hm_i - B)) \right)^2$$

Le système 1 présente l'avantage de ne pas mettre en œuvre un procédé amont de compensation des harmonisations] où Hmi, i= 1 à N, avec N>1, représentent les valeurs de champ magnétique exprimées dans le référentiel Ra aux temps de mesure Ti et Vi est le vecteur de projection sur l'axe vertical du référentiel de base R, i.e. Vi = [-sin($\theta$i) ; sin($\varphi$i).cos($\theta$i) ; cos($\varphi_i$).cos($\theta$i)], où $\theta_i$ représente la valeur de tangage de l'engin et $\varphi_i$ celle de roulis de l'avion aux temps de mesure $T_i$.

Dans le mode de réalisation décrit ci-dessous, une méthode itérative d'estimation du minimum de C1 est utilisée.

Le bloc de calcul de cap 4 comprend un sous-bloc de pré-traitement 4.1 et un sous-bloc de traitement 4.2, adaptés pour mettre en œuvre les étapes du procédé 100 de calcul de cap décrites ci-dessous en référence à la figure 2. Le procédé 100 comprend un premier sous-processus 101 de pré-traitement, comprenant les étapes 102 à 105, puis une étape 106 de traitement de compensation et une étape 107 de calcul de cap.

Le bloc de calcul de cap 4 est adapté pour collecter les valeurs de champ magnétique fournies par le magnétomètre 2 et les valeurs des angles de roulis, de tangage et de cap fournies par la centrale à inertie 3, et les mémoriser, dans une mémoire, en association avec les temps de mesure successifs.

Dans un mode de réalisation, le bloc de calcul de cap 4 comprend un processeur et les opérations, ou certaines au moins de ces opérations, réalisées par le bloc de calcul de cap 4 et décrits ci-dessous en référence à la figure 2 notamment, sont mis en œuvre suite à l'exécution, sur le processeur, d'instructions logicielles stockées dans la mémoire.

Ainsi, en référence à la figure 2, dans une étape 102 du sous-processus de pré-traitement 101, le sous-bloc de pré-traitement 4.1 collecte les valeurs de N vecteurs 3D exprimés dans le référentiel de l'avion $R_a$ de champ magnétique mesurées par le magnétomètre 2 à des temps de mesure $T_i$, i= 1 à N, N>1, au cours du vol de l'avion (par exemple avec une trajectoire comportant au moins deux virages avec prise de roulis dans un sens et dans l'autre et un décollage, pour la prise de tangage).

Le sous-bloc de calibration de compensation 4.1 collecte en outre les 2N valeurs d'angle de roulis, de tangage fournies par la centrale à inertie 3 pour l'avion pour ces temps de mesure $T_i$, i= 1 à N.

Dans une étape 103, les valeurs des N vecteurs 3D de champ magnétique et les 2N valeurs d'angle de roulis et de tangage pour les instants $T_i$, i= 1 à N, collectées sont filtrées par le sous-bloc de pré-traitement 4.1, à l'aide d'un filtre passe-bas. La fréquence de coupure du filtre passe-bas est choisie supérieure à la bande passante de la trajectoire de l'avion. Les caractéristiques de trajectoire de l'avion dont le spectre est considéré comprennent le roulis, le tangage, le cap. Les valeurs de champ et d'angles considérées par la suite sont celles issues de ce filtrage.

Puis dans une étape 104, le sous-bloc de pré-traitement 4.1 définit une solution initiale $(A_0, B_0)$ pour le couple (A, B) qui servira de point de départ à la recherche itérative d'un minimum de l'expression C1. Dans un mode de réalisation, la solution initiale est déterminée par la méthode de l'estimateur des moindres carrés exploitant également les hypothèses Hyp1 et Hyp2 et les valeurs de champ magnétique et d'angles filtrées issues de l'étape 103.

Dans une étape 105, le sous-bloc de pré-traitement 4.1 estime la valeur du couple (A, B) minimisant l'expression C1. Dans le cas considéré, il effectue une descente de gradient à partir de la solution initiale obtenue à l'étape 104 avec la minimisation du critère C1 :

$$\sum_{i=1 \, \grave{a} \, N} \left( \|A(Hm_i - B)\| - \frac{1}{N} \sum_{i=1 \, \grave{a} \, N} (\|A(Hm_i - B)\|) \right)^2 + \sum_{i=1 \, \grave{a} \, N} \left( V_i A(Hm_i - B) - \frac{1}{N} \sum_{i=1 \, \grave{a} \, N} (V_i A(Hm_i - B)) \right)^2$$

où :

- $Hm_i$, i= 1 à N, avec N>1, sont les valeurs de champ magnétique (après filtrage de l'étape 103) correspondant aux temps de mesure $T_i$ et
- $V_i$ est le vecteur de projection sur l'axe vertical du référentiel de base R, i.e. $V_i$ = [-sin($\theta_i$) ; sin($\varphi_i$).cos($\theta_i$) ; cos($\varphi_i$).cos($\theta_i$)], où $\theta_i$ est la valeur de tangage de l'engin et $\varphi_i$ celle de roulis de l'avion aux temps de mesure $T_i$ (après filtrage de l'étape 103).

Ce critère de minimisation prend en compte les erreurs fers dur et doux ainsi que l'harmonisation des alignements du référentiel avion et du référentiel magnétomètre en même temps. Contrairement aux méthodes classiques qui minimisent le premier groupe de termes du critère C1 vis-à-vis d'une valeur fixe à la place de la moyenne de la norme de A(Hm-B) (1 par exemple dans le critère suivant: $C2=\sum(\|A(Hm-B)\|-1)^2$) et pour lesquelles on ne peut plus (sans connaissance supplémentaire) se donner de valeur fixe pour le champ magnétique Z une fois que l'on a fixé la valeur de la norme à 1. Dans le critère C1, on satisfait les deux critères à la fois sans faire d'hypothèses sur les valeurs du champ mis à part que celui-ci est constant en norme et en valeur verticale. Bien entendu on voit que si l'on prend A et B nuls, le critère C1 est pleinement satisfait. C'est pourquoi on contraint une ou plusieurs composantes à une valeur fixe. Par exemple dans le mode de réalisation considéré, la valeur A(1,1) est fixée égale à 1 (ou autre constante) dans la résolution : il y aura donc au final 11 inconnues (8 pour la matrice A et 3 pour la matrice B).

La descente de gradient est alors effectuée de manière classique par le sous-bloc de pré-traitement 4.1 à l'aide d'un algorithme réitérant l'ensemble d'étapes E1 à E5, étant donné un couple (A, B) précédemment calculé :
E1 : on calcule le gradient de C1 par rapport à A et B.

Le calcul du gradient de C1 peut se faire de manière analytique dans ce cas et s'exprime à partir des termes ci-dessous, en notant : $u_i = (H_i - B)$,

$$\frac{\partial \left( \|Au_i\| - \frac{1}{N} \sum_{i=1}^{N} (\|Au_i\|) \right)^2}{\partial A} = 2 \left( \|Au_i\| - \frac{1}{N} \sum_{i=1}^{N} (\|Au_i\|) \right) \left( \frac{u_i \otimes Au_i}{\|Au_i\|} - \frac{1}{N} \sum_{i=1}^{N} (\frac{u_i \otimes Au_i}{\|Au_i\|}) \right)$$

$$\frac{\partial \left( \|Au_i\| - \frac{1}{N} \sum_{i=1}^{N} (\|Au_i\|) \right)^2}{\partial B} = 2 \left( \|Au_i\| - \frac{1}{N} \sum_{i=1}^{N} (\|Au_i\|) \right) \left( -\frac{A^t Au_i}{\|Au_i\|} + \frac{1}{N} \sum_{i=1}^{N} (\frac{A^t Au_i}{\|Au_i\|}) \right)$$

$$\frac{\partial \left( V_i Au_i - \frac{1}{N} \sum_{i=1}^{N} (V_i Au_i) \right)^2}{\partial A} = 2 \left( V_i Au_i - \frac{1}{N} \sum_{i=1}^{N} (V_i Au_i) \right) \left( u_i \otimes V_i^t - \frac{1}{N} \sum_{i=1}^{N} (u_i \otimes V_i^t) \right)$$

$$\frac{\partial \left( V_i Au_i - \frac{1}{N} \sum_{i=1}^{N} (V_i Au_i) \right)^2}{\partial B} = 2 \left( V_i Au_i - \frac{1}{N} \sum_{i=1}^{N} (V_i Au_i) \right) \left( -A^t V_i^t + \frac{1}{N} \sum_{i=1}^{N} (A^t V_i^t) \right)$$

où $\otimes$ désigne le symbole de kronecker.

E2 : On calcule la direction de descente optimale locale à partir de l'inverse de la Hessienne de C1 calculée à l'itération précédente (et qu'on aura pu initialiser à l'identité).

E3 : On recherche le pas optimal suivant la direction optimale (recherche linéaire), avec la méthode algorithmique d'Armijo par exemple. On en déduit une nouvelle estimation de (A, B) pour l'itération courante.

E4 : On estime l'inverse de la Hessienne de C1 à partir d'une méthode existante : méthode DFP (Davidon-Fletcher-Powell) ou BFGS (Broyden-Fletcher-Goldfarb-Shanno) par exemple.

E5 : on réitère le procédé de E1 à E4 jusqu'à ce qu'un critère de convergence (C1 inférieur à une valeur-seuil) ou un nombre-seuil d'itérations soit atteint. Le couple (A, B) estimé est alors obtenu.

La calibration étant ainsi achevée, les calculs de compensation de champ mesuré et de calcul du cap correspondant peuvent être effectués.

Dans une étape 106 de compensation mise en œuvre sur la base de la précédente phase de calibration, le sous-bloc de traitement 4.2 reçoit une nouvelle valeur (3D) de champ mesuré Hm qui lui est fournie par le magnétomètre 2 et détermine le champ compensé Hc correspondant en fonction de cette valeur Hm, et de A et B estimés à l'étape 105 : $Hc = A(Hm - B)$.

Dans une étape 107, le sous-bloc de traitement 4.2 calcule le cap magnétique Cap de l'avion à partir des composantes du champ magnétique mesuré compensé Hc déterminé à l'étape 106 : Cap = atan2($Hc_y$,$Hc_x$) où $Hc_x$, $Hc_y$ sont les composantes sur les axes X et Y du champ magnétique mesuré compensé projeté dans le plan horizontal terrestre. La projection se fait en utilisant les angles d'attitude issus de la centrale à inertie 3 pour le temps de mesure correspondant à la mesure du champ Hm.

La calibration de compensation proposée pourra se faire en vol avec un modèle à 11 états ou au sol avec un modèle réduit pour garantir l'observabilité du système.

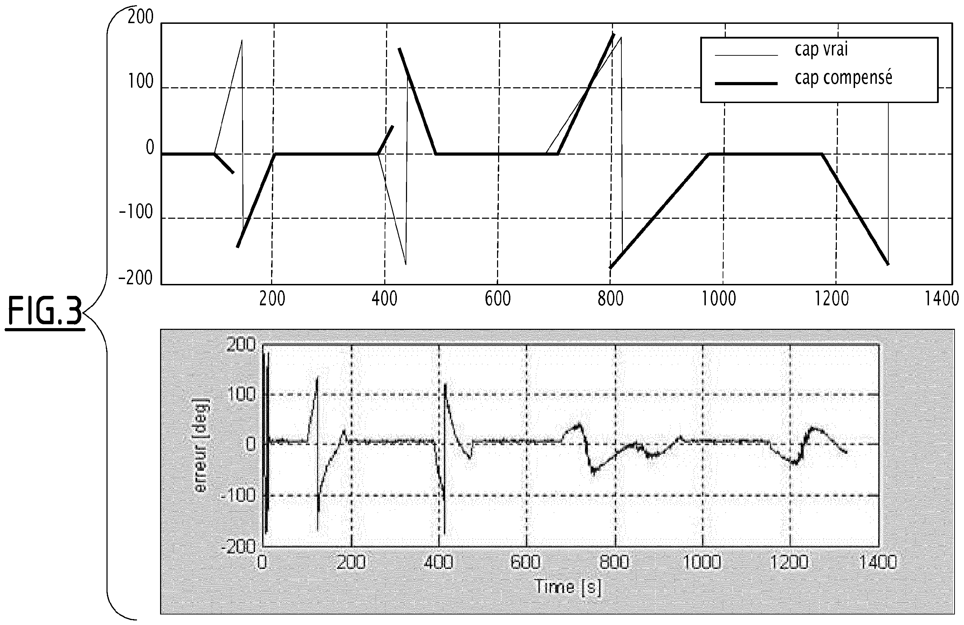

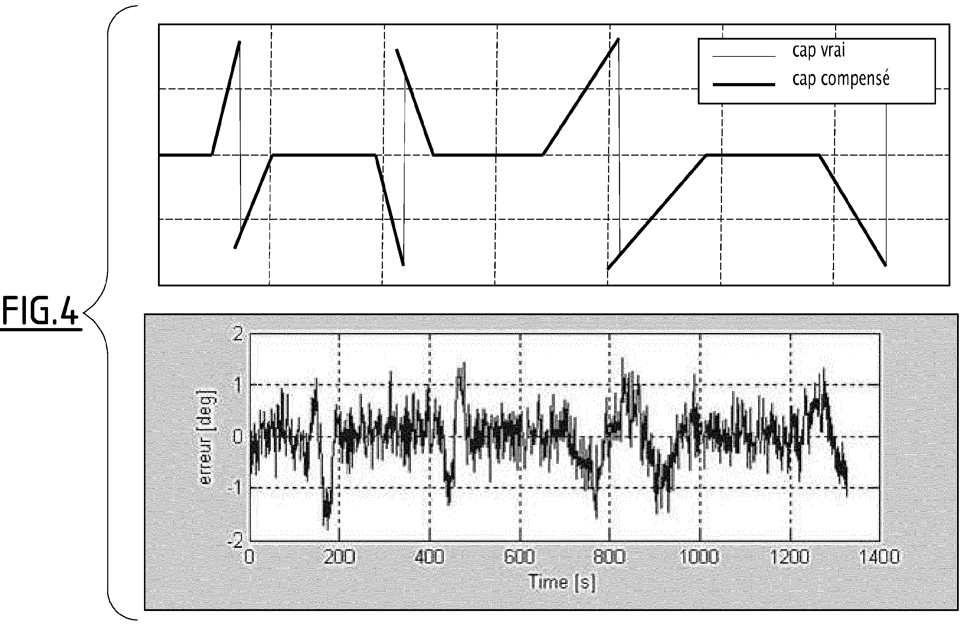

Les figures 3 et 4 illustrent les résultats obtenus sur une simulation théorique à partir de mesures communes initiales de champ magnétique et d'angles avec les hypothèses suivantes :

- la calibration de compensation se fait à 70° de latitude,
- les mesures de roulis et de tangage sont exactes
- le bruit de mesure est de 0,005 Oe
- lorsqu'on réalise un filtrage sur le champ, le même filtrage est également appliqué sur les angles de roulis et tangage.

Sur chacune des figures 3 et 4, sur le graphe en partie haute de la figure, les valeurs de cap vrai et compensé sont indiquées en ordonnée en fonction du temps indiqué en abscisse tandis que sur le graphe en partie basse de la figure, l'erreur entre cap vrai et compensé figure en ordonnée. La figure 3 correspond à une compensation sur la base d'une calibration de compensation avec un estimateur des moindres carrés (i.e A et B déterminés par la seule solution initiale), tandis que la figure 4 correspond à une compensation sur la base d'une calibration de compensation avec une estimation des moindres carrés ayant initiée une descente de gradient avec filtrage comme décrit plus haut.

La présente invention offre une solution de compensation de bonne qualité pour toutes les latitudes. Elle est robuste aux bruits de mesure, corrige simultanément les perturbations de fer doux, de fer dur et d'alignement, harmonisant ainsi l'avion et le magnétomètre. Elle ne pré-suppose aucune connaissance sur le champ magnétique réel ou théorique, ni aucune connaissance sur le cap vrai (i.e. par rapport au Nord géographique), ou le cap magnétique local (i.e. par rapport au Nord magnétique).

L'invention est particulièrement avantageuse pour des latitudes élevées et est bien évidemment aussi intéressante pour toute valeur de latitude.

On notera que l'opération de calibration dans un autre mode de réalisation de l'invention, est effectuée sans l'étape de filtrage 103. Dans des modes de réalisation, d'autres méthodes que celles proposées sont retenues pour définir une solution initiale pour l'algorithme itératif d'approximation du minimum de C1 ou pour estimer un minimum de l'expression C1.

Le mode de réalisation décrit ci-dessus en référence aux figures se référait à un avion. L'invention est bien sûr utilisable dans d'autres types d'engins, tels que des drones, etc.

**Revendications**

1. Procédé de compensation (100) d'un champ magnétique déterminé à bord d'un engin à l'aide d'un capteur (2) de champ magnétique embarqué à bord de l'engin en vue de calculer le cap magnétique dudit engin, ledit procédé comprenant les étapes mises en œuvre par ordinateur et consistant à :

   - pour chaque temps de mesure $T_i$, i= 1 à N avec N>1, on collecte les valeurs du champ magnétique 3D $Hm_i$ en provenance du capteur (2) de champ magnétique et celles des angles $\theta_i$ et $\varphi_i$, où $\theta_i$ est le tangage de l'engin et $\varphi_i$ est le roulis de l'engin ;

- on détermine une matrice A et un vecteur B en fonction au moins desdites valeurs collectées de champ magnétique $Hm_i$ et des angles $\theta_i$ et $\varphi_i$, i= 1 à N, la matrice A représentant les perturbations de fer doux et de non-alignement entre l'engin et le capteur de champ magnétique et le vecteur B représentant les perturbations de fer dur ; et

ledit procédé étant **caractérisé en ce que** la détermination de la matrice A et du vecteur B comprend une étape d'estimation (105) du couple (A,B) minimisant l'expression

$$\sum_{i=1 \, à \, N}\left(\|A(Hm_i-B)\| - \frac{1}{N}\sum_{i=1 \, à \, N}(\|A(Hm_i-B)\|)\right)^2 + \sum_{i=1 \, à \, N}\left(V_iA(Hm_i-B) - \frac{1}{N}\sum_{i=1 \, à \, N}(V_iA(Hm_i-B))\right)^2$$

où $V_i = [-\sin(\theta_i) ; \sin(\varphi_i).\cos(\theta_i) ; \cos(\varphi_i).\cos(\theta_i)]$.

2. Procédé de compensation (100) d'un champ magnétique selon la revendication 1, selon lequel une opération (103) de filtrage passe-bas, dont la fréquence de coupure est supérieure à la bande passante de la trajectoire de l'engin **caractérisée par** les signaux de roulis, tangage et cap, est appliquée sur les valeurs des champs magnétiques $Hm_i$ et des angles $\theta_i$ et $\varphi_i$, ladite étape d'estimation du couple (A,B) étant réalisée en fonction desdites valeurs filtrées.

3. Procédé de compensation (100) d'un champ magnétique selon la revendication 1 ou 2, selon lequel l'étape d'estimation (105) du couple (A,B) minimisant ladite expression est réalisée par un algorithme itératif de descente de gradient de ladite expression.

4. Procédé de compensation (100) d'un champ magnétique selon l'une des revendications précédentes, selon lequel on détermine un cap magnétique de l'engin en fonction d'un champ magnétique compensé, ledit champ magnétique compensé étant fonction d'au moins un champ magnétique déterminé à l'aide du capteur (2) de champ magnétique, de ladite matrice A et dudit vecteur B précédemment déterminés.

5. Dispositif de compensation (4) d'un champ magnétique déterminé à bord d'un engin, ledit dispositif étant adapté pour collecter pour chaque temps de mesure $T_i$, i= 1 à N avec N>1, des valeurs du champ magnétique 3D mesuré $Hm_i$ et celles des angles $\theta_i$ et $\varphi_i$, où $\theta_i$ est le tangage de l'engin et $\varphi_i$ est le roulis de l'engin et pour déterminer une matrice A et un vecteur B en fonction au moins desdites valeurs collectées de champ magnétique $Hm_i$ et des angles $\theta_i$ et $\varphi_i$, i= 1 à N, la matrice A représentant les perturbations de fer doux et de non-alignement entre l'engin et le capteur de champ magnétique et le vecteur B représentant les perturbations de fer dur ; ledit dispositif étant **caractérisé en ce que**, lors de la détermination de la matrice A et du vecteur B, il est adapté pour estimer le couple (A,B) en minimisant l'expression

$$\sum_{i=1 \, à \, N}\left(\|A(Hm_i-B)\| - \frac{1}{N}\sum_{i=1 \, à \, N}(\|A(Hm_i-B)\|)\right)^2 + \sum_{i=1 \, à \, N}\left(V_iA(Hm_i-B) - \frac{1}{N}\sum_{i=1 \, à \, N}(V_iA(Hm_i-B))\right)^2$$

où $V_i = [-\sin(\theta_i) ; \sin(\varphi_i).\cos(\theta_i) ; \cos(\varphi_i).\cos(\theta_i)]$.

6. Dispositif de compensation (4) d'un champ magnétique selon la revendication 5, comprenant un filtre passe-bas, dont la fréquence de coupure est supérieure à la bande passante de la trajectoire de l'engin **caractérisée par** les signaux de roulis, tangage et cap, étant adapté pour filtrer les valeurs des champs magnétiques $Hm_i$ et des angles $\theta_i$ et $\varphi_i$, l'estimation du couple (A,B) étant réalisée en fonction desdites valeurs filtrées.

7. Dispositif de compensation (4) d'un champ magnétique selon la revendication 5 ou 6, adapté pour mettre en œuvre un algorithme itératif de descente de gradient de ladite expression pour estimer le couple (A,B) minimisant ladite expression.

8. Dispositif de compensation (4) d'un champ magnétique selon l'une des revendications 5 à 7, adapté pour déterminer un cap magnétique de l'engin en fonction d'un champ magnétique compensé, ledit champ magnétique compensé étant fonction d'au moins un champ magnétique mesuré, de ladite matrice A et dudit vecteur B précédemment déterminés.

9. Programme d'ordinateur comportant des instructions logicielles qui, lorsqu'elles sont exécutées par un ordinateur, mettent en œuvre un procédé de compensation (100) d'un champ magnétique selon l'une des revendications 1 à 4.

**Patentansprüche**

1. Verfahren zur Kompensation (100) eines Magnetfelds, welches an Bord eines Fahrzeugs ermittelt wird mittels eines Magnetfeldsensors (2), welcher sich an Bord des Fahrzeugs befindet, um dem magnetischen Kurs des Fahrzeugs zu berechnen, wobei das Verfahren die Schritte aufweist, welche durch einen Computer umgesetzt werden und gebildet sind durch:

   - für jede Messzeit $T_i$, wobei i = 1 bis N mit N > 1, Sammeln von Werten eines 3D-Magnetfelds Hmi, stammend vom Magnetfeldsensor (2), und die der Winkel $\theta_i$ und $\varphi_i$, wobei $\theta_i$ das Nicken des Fahrzeugs ist und $\varphi_i$ das Rollen des Fahrzeugs ist,
   - Ermitteln einer Matrix A und eines Vektors B in Abhängigkeit von mindestens den gesammelten Werten des Magnetfelds $Hm_i$ und der Winkel $\theta_i$ und $\varphi_i$, mit i = 1 bis N, wobei die Matrix A Weicheisen-Störungen und Nichtausrichtung-Störungen zwischen dem Fahrzeug und dem Magnetfeldsensor repräsentiert und der Vektor B die Harteisen-Störungen repräsentiert, und

   wobei das Verfahren **dadurch gekennzeichnet ist, dass** das Ermitteln der Matrix A und des Vektors B aufweist einen Schritt des Berechnens (105) eines Paars (A,B), welches die Gleichung

$$\sum_{i=1\ bis\ N}\left(\|A(Hm_i-B)\|-\frac{1}{N}\sum_{i=1\ bis\ N}(\|A(Hm_i-B)\|)\right)^2 + \sum_{i=1\ bis\ N}\left(V_iA(Hm_i-B)-\frac{1}{N}\sum_{i=1\ bis\ N}(V_iA(Hm_i-B))\right)^2$$

   minimiert, wobei $V_i=[-\sin(\theta_i); \sin(\varphi_i).\cos(\theta_i); \cos(\varphi_i).\cos(\theta_i)]$.

2. Verfahren zur Kompensation (100) eines Magnetfelds gemäß dem Anspruch 1, gemäß welchem ein Vorgang (103) des Tiefpassfilterns, bei dem die Grenzfrequenz größer ist als die Bandbreite der Trajektorie des Fahrzeugs, welche durch die Signale des Rollens, Nickens und Kurses gekennzeichnet wird, auf die Werte des Magnetfelds $Hm_i$ und der Winkel $\theta_i$ und $\varphi_i$ angewendet wird, wobei der Schritt des Berechnens des Paars (A,B) in Abhängigkeit von den gefilterten Werten umgesetzt wird.

3. Verfahren zur Kompensation (100) eines Magnetfelds gemäß dem Anspruch 1 oder 2, gemäß welchem der Schritt des Berechnens (105) des Paars (A,B), welches die genannte Gleichung minimiert, durch einen iterativen Algorithmus des Gradientenabstiegs der genannten Gleichung umgesetzt wird.

4. Verfahren zur Kompensation (100) eines Magnetfelds gemäß irgendeinem der vorhergehenden Ansprüche, gemäß welchem ein magnetischer Kurs des Fahrzeugs in Abhängigkeit von einem kompensierten Magnetfeld bestimmt wird, wobei das kompensierte Magnetfeld von mindestens einem mittels des Magnetfeldsensors (2) ermittelten Magnetfeld, der Matrix A und dem Vektor B, welche zuvor bestimmt wurden, abhängig ist.

5. Vorrichtung zur Kompensation (4) eines Magnetfelds, welches an Bord eines Fahrzeugs ermittelt wird, wobei die Vorrichtung dazu eingerichtet ist, für jede Messzeit $T_i$, wobei i = 1 bis N mit N > 1, Werte eines gemessenen 3D-Magnetfelds Hmi, und die der Winkel $\theta_i$ und $\varphi_i$, wobei $\theta_i$ das Nicken des Fahrzeugs ist und $\varphi_i$ das Rollen des Fahrzeugs ist, zu sammeln und eine Matrix A und eines Vektors B in Abhängigkeit von mindestens den gesammelten Werten des Magnetfelds $Hm_i$ und der Winkel $\theta_i$ und $\varphi_i$, mit i = 1 bis N, zu ermitteln, wobei die Matrix A Weicheisen-Störungen und Nichtausrichtung-Störungen zwischen dem Fahrzeug und dem Magnetfeldsensor repräsentiert und der Vektor B die Harteisen-Störungen repräsentiert, wobei die Vorrichtung **gekennzeichnet dadurch** ist, sie bei dem Ermitteln der Matrix A und des Vektors B dazu eingerichtet ist, das Paar (A,B) unter Minimieren der Gleichung

$$\sum_{i=1\ bis\ N}\left(\|A(Hm_i-B)\|-\frac{1}{N}\sum_{i=1\ bis\ N}(\|A(Hm_i-B)\|)\right)^2 + \sum_{i=1\ bis\ N}\left(V_iA(Hm_i-B)-\frac{1}{N}\sum_{i=1\ bis\ N}(V_iA(Hm_i-B))\right)^2$$

zu berechnen, wobei $V_i$=[-sin($\theta_i$); sin($\varphi_i$).cos($\theta_i$); cos($\varphi_i$).cos($\theta_i$)].

6. Vorrichtung zur Kompensation (4) eines Magnetfelds gemäß dem Anspruch 5, aufweisend einen Tiefpassfilter, dessen Grenzfrequenz größer ist als die Bandbreite der Trajektorie des Fahrzeugs, welche durch die Signale des Rollens, Nickens und Kurses gekennzeichnet wird, eingerichtet zum Filtern der Werte des Magnetfelds $Hm_i$ und der Winkel $\theta_i$ und $\varphi_i$, wobei das Berechnen des Paars (A,B) in Abhängigkeit von den gefilterten Werten umgesetzt wird.

7. Vorrichtung zur Kompensation (4) eines Magnetfelds gemäß dem Anspruch 5 oder 6, welche dazu eingerichtet ist, einen iterativen Algorithmus des Gradientenabstiegs der genannten Gleichung durchzuführen, um das Paar (A,B), welches die genannte Gleichung minimiert, zu berechnen.

8. Vorrichtung zur Kompensation (4) eines Magnetfelds gemäß irgendeinem der Ansprüche 5 bis 7, welche dazu eingerichtet ist, ein magnetischer Kurs des Fahrzeugs in Abhängigkeit von einem kompensierten Magnetfeld bestimmt wird, wobei das kompensierte Magnetfeld von mindestens einem mittels des Magnetfeldsensors (2) ermittelten Magnetfeld, der Matrix A und dem Vektor B, welche zuvor bestimmt wurden, abhängig ist.

9. Computerprogramm, welches logische Anweisungen aufweist, welche, bei deren Ausführung durch einen Computer, ein Verfahren zur Kompensation (100) eines Magnetfelds gemäß einem der Ansprüche 1 bis 4 umsetzen.

Claims

1. A compensation method (100) for a magnetic field determined on board a vehicle using a magnetic field sensor (2) on board a vehicle in order to calculate the magnetic heading of said vehicle, said method comprising the steps carried out by computer and consisting of:

- for each measuring time $T_i$, i= 1 to N with N>1, collecting the values of the 3D magnetic field $Hm_i$ coming from the magnetic field sensor (2) and the angles $\theta_i$ and $\varphi_i$, where $\theta_i$ is the pitch of the vehicle $\varphi_i$ is the roll of the vehicle;
- determining a matrix A and a vector B as a function at least of said collected magnetic field values $Hm_i$ and angles $\theta_i$ and $\varphi_i$, i= 1 to N, the matrix A representing the soft iron and nonalignment disruptions between the vehicle and the magnetic field sensor and the vector B representing the hard iron disruptions; and

said method being **characterized in that** the determination of the matrix A and the vector B comprises a step for estimating (105) the pair (A,B) minimizing the expression

$$\sum_{i=1 \, \grave{a} \, N}\left(\left\|A(Hm_i-B)\right\| - \frac{1}{N}\sum_{i=1 \, \grave{a} \, N}\left(\left\|A(Hm_i-B)\right\|\right)\right)^2 + \sum_{i=1 \, \grave{a} \, N}\left(V_i A(Hm_i-B) - \frac{1}{N}\sum_{i=1 \, \grave{a} \, N}(V_i A(Hm_i-B))\right)^2$$

where $V_i$ = [-sin($\theta_i$); sin($\varphi_i$).cos($\theta_i$); cos($\varphi_i$).cos($\theta_i$)].

2. The magnetic field compensation method (100) according to claim 1, according to which a low-pass filtering operation (103), the cutoff frequency of which is higher than the bandwidth of the trajectory of the vehicle that is **characterized by** heading, pitch and roll signals, is applied to the magnetic field values $Hm_i$ and angles $\theta_i$ and $\varphi_i$, said step for estimating the pair (A,B) being carried out based on said filtered values.

3. The magnetic field compensation method (100) according to claim 1 or 2, wherein the step for estimating (105) the pair (A,B) minimizing said expression is carried out by an iterative gradient descent algorithm of said expression.

4. The magnetic field compensation method (100) according to one of the preceding claims, wherein a magnetic heading of the vehicle is determined based on a compensated magnetic field, said compensated magnetic field depending on at least a magnetic field determined using the magnetic field sensor (2), said matrix A and said vector B previously determined.

5. A compensation device (4) for a determined magnetic field on board a vehicle, said device being configured for collecting, for each measuring time $T_i$, i= 1 to N with N>1, values of the measured 3D magnetic field $Hm_i$ and those of the angles $\theta_i$ and $\varphi_i$, where $\theta_i$ is the pitch of the vehicle and $\varphi_i$ is the roll of the vehicle, and for determining a matrix A and a vector B as a function at least of said collected magnetic field values $Hm_i$ and angles $\theta_i$ et $\varphi_i$, i= 1 to N, the matrix A representing the soft iron and nonalignment disruptions between the vehicle and the magnetic field sensor and the vector B representing the hard iron disruptions;

said device being **characterized in** being configured, during the determination of the matrix A and the vector B, for estimating the pair (A,B) by minimizing the expression

$$\sum_{i=1\,\text{à}\,N}\left(\left\|A(Hm_i-B)\right\|-\frac{1}{N}\sum_{i=1\,\text{à}\,N}\left(\left\|A(Hm_i-B)\right\|\right)\right)^2 + \sum_{i=1\,\text{à}\,N}\left(V_i A(Hm_i-B)-\frac{1}{N}\sum_{i=1\,\text{à}\,N}(V_i A(Hm_i-B))\right)^2$$

where $V_i = [-\sin(\theta_i); \sin(\varphi_i).\cos(\theta_i); \cos(\varphi_i).\cos(\theta_i)]$.

6. The magnetic field compensation device (4) according to claim 5, comprising a low-pass filter, the cutoff frequency of which is higher than the bandwidth of the trajectory of the vehicle that is **characterized by** heading, pitch and roll signals, said low-pass filter being suitable for filtering the magnetic field values $Hm_i$ and angles $\theta_i$ and $\varphi_i$, the estimation of the pair (A,B) being carried out based on said filtered values.

7. The magnetic field compensation method (4) according to claim 5 or 6, suitable for implementing an iterative gradient descent algorithm of said expression for estimating the pair (A,B) minimizing said expression.

8. The magnetic field compensation device (4) according to one of claims 5 to 7, suitable for determining a magnetic heading of the vehicle based on a compensated magnetic field, said compensated magnetic field depending on at least one measured magnetic field, said matrix A and said vector B previously determined.

9. A computer program comprising software instructions which, when executed by a computer, carry out a magnetic field compensation method (100) according to one of claims 1 to 4.

FIG.1

FIG.2

FIG.3

FIG.4

## RÉFÉRENCES CITÉES DANS LA DESCRIPTION

**Documents brevets cités dans la description**

- EP 0718598 B1